# FASCICULE DE BREVET EUROPEEN

(11) **EP 3 857 610 B1**
(45) Date de publication et mention de la délivrance du brevet: **20.07.2022**
(21) Numéro de dépôt: 19829287.2
(22) Date de dépôt: 19.11.2019
(51) Int. Cl.: H01L 31/02, H01L 31/18, H01L 23/544

(54) **CELLULE SOLAIRE PHOTOVOLTAIQUE PRESENTANT DES FONCTIONS DE STOCKAGE D'INFORMATION ET D'AFFICHAGE**
PHOTOVOLTAISCHE SOLARZELLE MIT INFORMATIONSSPEICHER- UND ANZEIGEFUNKTIONEN
PHOTOVOLTAIC SOLAR CELL HAVING INFORMATION STORAGE AND DISPLAY FUNCTIONS

(30) Priorité: 29.11.2018 FR 1872092; 29.11.2018 FR 1872093
(43) Date de publication de la demande: 04.08.2021
(73) Titulaire: COMMISSARIAT À L'ÉNERGIE ATOMIQUE ET AUX ÉNERGIES ALTERNATIVES, 75015 Paris (FR)
(72) Inventeur: LORFEUVRE, Coralie, 38054 GRENOBLE CEDEX 09 (FR); BENMANSOUR, Malek, 38054 GRENOBLE CEDEX 09 (FR); DESRUES, Thibaut, 38054 GRENOBLE CEDEX 09 (FR); DUBOIS, Sébastien, 38054 GRENOBLE CEDEX 09 (FR); RAKOTONIAINA, Jean-Patrice, 38054 GRENOBLE CEDEX 09 (FR)
(74) Mandataire: Brevalex
(86) Numéro de dépôt international: PCT/FR2019/052742
(87) Numéro de publication internationale: WO 2020/109696

(56) Documents cités:
- WO-A1-2012/043625
- US-A1- 2009 050 198
- US-A1- 2013 160 832

## Description

### DOMAINE TECHNIQUE

L'invention concerne le domaine des cellules solaires encore appelées cellules photovoltaïques (PV) et plus particulièrement celui de cellules dotées de moyens permettant d'assurer leur traçabilité.

Il est connu d'inscrire des informations sur une cellule solaire. Le document CN103489963 A prévoit par exemple l'inscription d'un code barre sur une cellule solaire à l'aide d'une technique d'irradiation au laser.

Cette technique est susceptible, pour certaines technologies de cellules, et du fait de l'échauffement important et localisé qu'elle génère, d'altérer les propriétés des couches actives ou des jonctions de la cellule.

Par ailleurs, l'utilisation d'un équipement laser pose des problèmes de coût du procédé de fabrication.

On cherche d'autre part, à réduire le temps nécessaire à la lecture d'informations inscrites sur la cellule, ce temps pouvant augmenter par exemple lorsqu'on doit en outre localiser la région où le code barre est positionné.

Le document US 2013/160832 A1 décrit un dispositif comprenant une cellule photovoltaïque munie d'une structure apte à émettre un rayonnement lumineux. La cellule comporte, sur une région d'une face principale, une première couche à travers laquelle un ou plusieurs motifs sont gravés, lesdits un ou plusieurs motifs étant répartis selon un agencement déterminé correspondant à au moins un symbole d'information. La première couche repose sur une deuxième couche avec laquelle ladite première couche forme une jonction. Le dispositif comprend également un circuit de polarisation configuré pour polariser en direct la jonction, de sorte que ladite jonction émette un rayonnement lumineux mettant en évidence lesdits motifs gravés.

Le document US 2009/050198 A1 décrit également un dispositif comprenant une cellule photovoltaïque disposant d'une inscription gravée, et un appareil opto-électronique de lecture de l'inscription gravée, de type scanner OCR.

Il se pose le problème de réaliser une cellule dotée d'un moyen permettant d'assurer sa traçabilité et qui soit amélioré vis-à-vis d'inconvénients mentionnés ci-dessus.

### EXPOSÉ DE L'INVENTION

Un mode de réalisation de la présente invention prévoit ainsi une cellule photovoltaïque munie d'une structure avec un ou plusieurs motifs gravés, la structure étant apte à émettre un rayonnement lumineux.

La cellule comporte sur une région d'une face principale, une première couche formant une jonction avec au moins une deuxième couche, la première couche comportant un ou plusieurs motifs gravés, lesdits un ou plusieurs motifs étant répartis selon un agencement déterminé correspondant à au moins un symbole d'information, ladite jonction étant, lorsqu'elle est polarisée en inverse, apte à émettre un rayonnement lumineux mettant en évidence lesdits un ou plusieurs motifs gravés dans ladite première couche.

Ainsi, avec une telle cellule, les motifs gravés sont mieux repérables.

L'information que ces motifs portent, par exemple un identifiant de la cellule ou un code indiquant son procédé de fabrication ou la technologie dans laquelle elle est réalisée, sont détectables plus aisément et plus rapidement.

La première couche peut être une couche de substrat semi-conducteur ou une couche rapportée ou formée sur un substrat semi-conducteur.

La deuxième couche peut être une couche de substrat semi-conducteur ou une couche rapportée ou formée sur un substrat semi-conducteur.

Dans une cellule solaire telle que définie plus haut, plusieurs types de jonction peuvent être prévus.

Selon un premier mode de réalisation particulier, la jonction peut être une homo-jonction de type pn. Dans ce cas, ladite première couche peut être une couche de matériau semi-conducteur cristallin et former cette homo-jonction avec une deuxième couche d'un substrat cristallin ou avec une deuxième couche sous forme de couche semi-conductrice cristalline reposant sur un substrat semi-conducteur.

Selon un deuxième mode de réalisation particulier, ladite première couche peut être une couche semi-conductrice amorphe dopée, ou un matériau multi-couches composé d'une couche semi-conductrice amorphe intrinsèque et d'une couche semi-conductrice amorphe dopée, et former avec la deuxième couche une hétéro-jonction. Dans ce cas, la deuxième couche peut être une couche de substrat cristallin ou une couche semi-conductrice cristalline reposant sur un substrat.

Selon un autre mode de réalisation particulier de la cellule photovoltaïque, ladite première couche peut être une couche métallique formant une jonction Schottky. Dans ce cas, la deuxième couche peut être une couche de substrat semi-conducteur, en particulier cristallin ou une couche semi-conductrice, en particulier en matériau semi-conducteur cristallin, reposant sur un substrat.

Selon une autre possibilité de mise en œuvre de la cellule photovoltaïque, la première couche peut être une couche métallique ou de matériau semi-conducteur polycristallin dopé d'un type de conductivité opposé à celui d'un substrat sur laquelle la première couche repose. Dans ce cas, une couche de matériau diélectrique peut être agencée entre le substrat et ladite première couche.

Selon une autre possibilité de mise en œuvre de la cellule photovoltaïque, ladite première couche peut être une couche d'oxyde métallique et former une hétéro-jonction. Dans ce cas, la deuxième couche peut être une couche de substrat cristallin, ou une couche semi-conductrice amorphe reposant sur un substrat, en particulier cristallin. Une couche de matériau diélectrique peut être disposée entre le substrat et ladite première couche.

Un mode de réalisation de la présente invention prévoit un module photovoltaïque doté d'une cellule photovoltaïque telle que définie plus haut.

A la cellule que l'on souhaite identifier on associe typiquement un moyen de polarisation ou un circuit de polarisation configuré pour polariser en inverse ladite jonction, en particulier à une tension proche, et préférentiellement inférieure (en valeur absolue), à la tension de claquage du dispositif complet, de sorte que ladite jonction émette un rayonnement lumineux.

Ainsi, selon un autre aspect, un mode de réalisation de la présente invention prévoit un dispositif doté d'une cellule photovoltaïque telle que définie plus haut et comprenant en outre un moyen de polarisation ou un circuit de polarisation configuré pour polariser en inverse ladite jonction.

Avantageusement, ce dispositif peut être doté d'un moyen d'acquisition d'image, tel qu'une caméra, prévu pour faire l'acquisition d'une image de ladite région, ladite tension de polarisation inverse étant appliquée pendant la durée de ladite acquisition.

Dans une cellule solaire telle que définie plus haut, lesdits motifs sont typiquement effectués par gravure mécanique. Une gravure à l'aide d'un outil permet en particulier de créer des rainures sans toutefois modifier de façon significative les caractéristiques des jonctions en polarisation directe, comme ce serait le cas en particulier si l'on formait les motifs à l'aide d'un laser. Une gravure mécanique est par ailleurs moins onéreuse qu'une gravure laser.

Ainsi, selon un autre aspect, la présente invention concerne un procédé de fabrication d'une cellule solaire telle que définie plus haut et dans lequel lesdits un ou plusieurs motifs sont effectués par gravure mécanique. Une gravure à l'aide d'un outil permet en particulier de créer des rainures sans toutefois modifier de façon significative les caractéristiques des jonctions en polarisation directe comme ce serait le cas en particulier si l'on formait les motifs à l'aide d'un laser. Une gravure mécanique est par ailleurs moins onéreuse qu'une gravure laser.

Typiquement, la gravure mécanique est réalisée par balayage d'une ou plusieurs pointes en contact avec ladite première couche ou par pressage d'un élément sur ladite première couche.

Selon un autre aspect, la présente invention concerne un procédé d'identification de cellule solaire comprenant des étapes de :
- polarisation en inverse de ladite jonction d'une cellule solaire telle que définie plus haut, de sorte qu'elle émette un rayonnement lumineux mettant en évidence lesdits motifs gravés dans ladite première couche de ladite cellule, puis
- la lecture de ladite information donnée, en particulier par acquisition d'une image desdits motifs gravés dans ladite première couche en utilisant un moyen d'acquisition d'image.

Une telle identification peut être effectuée avant l'assemblage de la cellule dans un module, et même lorsque la cellule se trouve intégrée dans un module photovoltaïque.

Une telle identification peut être utilisée lors d'un processus de tri de cellules solaires.

Ainsi, selon un autre aspect, la présente invention concerne également un procédé de tri de cellule solaires comprenant des étapes de :
- mise en œuvre d'un procédé d'identification tel que défini plus haut sur une première cellule solaire,
- mise en œuvre d'un procédé d'identification tel que défini plus haut sur une deuxième cellule solaire,
- répartir la première cellule et la deuxième cellule en un ou plusieurs groupes en fonction respectivement de l'information donnée lue sur la première cellule et de l'information donnée lue sur la deuxième cellule.

La première cellule peut être une cellule d'un premier module tandis que la deuxième cellule peut être une cellule d'un deuxième module distinct du premier module.

La première cellule comporte un premier symbole d'information qui peut être indicateur d'une technologie de fabrication dans laquelle les cellules du premier module sont réalisées. Une information concernant la technologie du premier module (par exemple relative au procédé d'interconnexion, au type d'encapsulant, à la nature du verre) peut être également indiquée.

Selon une possibilité de mise en œuvre du procédé, l'information donnée lue sur la première cellule est indicatrice d'une première technologie de fabrication dans laquelle les cellules du premier module sont réalisées tandis que ladite information donnée lue sur la deuxième cellule est indicatrice d'une deuxième technologie de fabrication dans laquelle les cellules du deuxième module sont réalisées.

Dans ce cas, le procédé comprend en outre une répartition des cellules du premier module en un premier groupe de cellules et des cellules du deuxième module en un deuxième groupe de cellules distinct du premier groupe.

Le procédé peut comprendre en outre préalablement à cette répartition, le démantèlement dudit premier module et dudit deuxième module.

L'identification peut être également utilisée lors d'un processus de recyclage de module(s) photovoltaïques ou de cellules solaire(s).

Ainsi, selon un autre aspect, la présente invention concerne un procédé de recyclage de cellule solaire ou de module photovoltaïque doté de plusieurs cellules solaires, comprenant :
- la mise en œuvre d'un procédé d'identification tel que défini plus haut sur une cellule solaire telle que définie précédemment, puis,
- le démantèlement de ladite cellule ou d'un module photovoltaïque dans laquelle ladite cellule donnée est intégrée en fonction de ladite information donnée identifiée par lecture desdits motifs gravés.

Avec un procédé d'identification tel que défini plus haut, il n'est pas nécessairement obligatoire de démonter un module photovoltaïque pour connaitre la composition de ses cellules, les cellules pouvant être identifiées alors même qu'elles se trouvent intégrées dans un module PV.

Lors de la mise en œuvre d'un procédé tel que défini plus haut, la cellule dont on souhaite lire l'information donnée peut être avantageusement disposée sur un socle de régulation en température configuré pour maintenir la température de la cellule à une valeur inférieure à 60°C, et préférentiellement inférieure à 30°C.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- Les figures 1A et 1B servent à illustrer un procédé d'inscription mécanique sur une face de cellule solaire de motifs au niveau d'une couche formant une jonction qui peut être polarisée en inverse de sorte à émettre un rayonnement lumineux, ce afin de mettre en évidence les motifs réalisés dans cette couche ;
- Les figures 2A, 2B, 3A, 3B, 4A, 4B, 5A, 5B servent à illustrer différents types de jonctions susceptibles d'être intégrées à une cellule solaire pour lui permettre de réaliser une fonction d'affichage par le biais de motifs gravés lumineux ;
- La figure 6 sert à illustrer un dispositif de lecture d'une telle structure d'affichage prévue sur une cellule solaire.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

En outre, dans la description ci-après, des termes qui dépendent de l'orientation, tels que « vertical », « latéral », « supérieur », « inférieur », etc. d'une structure s'appliquent en considérant que la structure est orientée de la façon illustrée sur les figures.

### EXPOSÉ DÉTAILLÉ DE MODES DE RÉALISATION PARTICULIERS

Une structure de départ possible pour la mise en œuvre d'une structure d'affichage sur une cellule solaire est un substrat 1 à base de matériau semi-conducteur, typiquement en silicium et qui peut être monocristallin ou multicristallin.

Dans le cas d'un substrat monocristallin, celui-ci peut être issu par exemple d'une technique de fabrication de type tirage Czochralski ou bien par technique de la zone fondue. Dans le cas d'un substrat en matériau multicristallin, celui-ci peut être formé par exemple par solidification dirigée en creuset (éventuellement assistée par reprise sur germe).

Le substrat se présente sous forme d'une plaque ou plaquette qui peut être dopée. Un dopage de type p par exemple à l'aide de Bore selon une concentration comprise par exemple entre 10¹³ at.cm⁻³ et 3×10¹⁷ at.cm⁻³ peut être prévu. En variante, un dopage de type n, par exemple à l'aide de Phosphore, selon une concentration comprise 10¹³ at.cm⁻³ et 3×10¹⁷ at.cm⁻³, peut être réalisé.

Le substrat 1 peut avoir une forme carrée ou « pseudo-carrée », c'est à dire avec des coins en biseau. Les côtés ou bords latéraux du substrat ont une dimension par exemple comprise entre 10 mm × 10 mm et 200 mm × 200 mm. L'épaisseur du substrat 1 est quant à elle typiquement comprise entre 5 µm et 800 µm, en particulier entre 40 µm et 300 µm.

Le substrat 1 comporte au moins une jonction ou est recouvert d'une couche avec lequel il forme une jonction ou est recouvert d'un empilement de couches formant au moins une jonction. On réalise dans une des couches permettant de former la jonction des motifs gravés d'une structure d'affichage lumineuse.

Une jonction est caractérisée par la présence locale, sans excitations électrique et lumineuse, d'un champ électrique permanent. L'Homme du Métier peut trouver des valeurs théoriques de champ électrique dans une jonction à partir d'un outil de calcul par exemple tel que celui disponible sur le site de Brigham Young University (BYU). Un logiciel, comme le logiciel PC1D, peut être par exemple utilisé pour déterminer ces valeurs dans le cas d'homo-jonctions en Si cristallin. Un logiciel tel que Afors-HET de l'institut HZB peut être employé par exemple pour trouver ces valeurs dans le cas d'hétérojonctions a-Si/c-Si

Pour une homo-jonction, la valeur maximale du champ électrique est généralement supérieure à 10 kV/cm.

Pour une jonction Schottky formée par exemple d'une couche d'Al sur une couche de Si dopé p, on détermine la valeur du champ électrique maximale à l'interface métal/silicium E=q×[B]×W/epsilon Si. Pour cela, on peut au préalable évaluer la largeur W de la zone de charge d'espace à partir d'un calculateur disponible dans l'outil développé par l'Université BYU. Par exemple pour une teneur [B] en Bore de 1×10¹⁶ cm⁻³, cette largeur peut être de l'ordre de W=16 nm. On détermine alors la valeur du champ électrique maximale à l'interface métal/silicium E=q×[B]×W/epsilon Si qui est de l'ordre de 2,5 kV/cm.

Pour une hétérojonction formée de silicium cristallin dopé n et de silicium amorphe hydrogéné a-Si:H (la couche de silicium amorphe étant constituée d'une région intrinsèque et d'une région dopée p) une simulation effectuée à l'aide d'Afors-HET donne par exemple une valeur de champ électrique maximale d'environ 100 kV/cm.

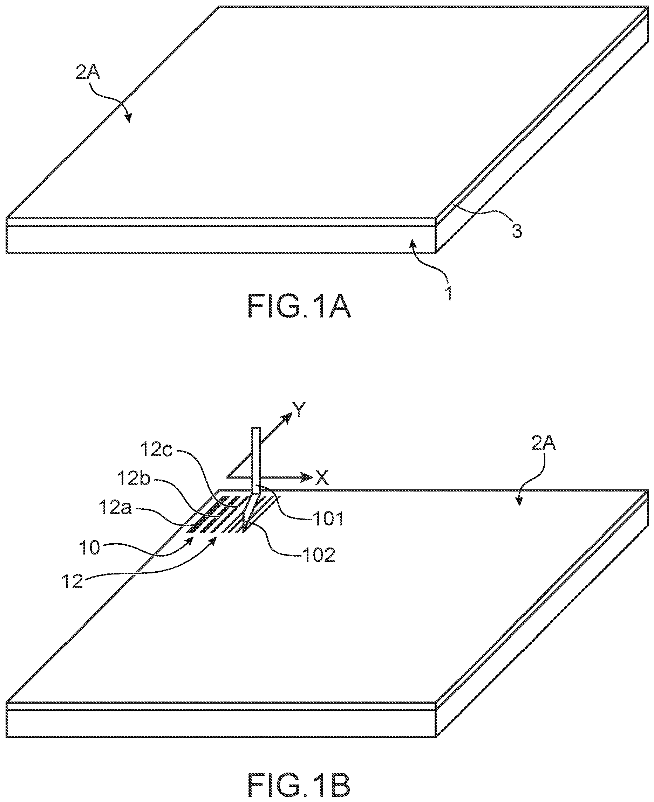

Dans l'exemple de réalisation illustré sur la figure 1A, le substrat 1 comporte sur une région d'une première face 2A parmi ses faces principales 2A, 2B une couche 3 permettant la collecte de porteurs charges minoritaires. Par exemple, la couche 3 permet la collecte d'électrons dans le cas où le substrat 1 est globalement dopé et selon un dopage de type p. La couche 3 permettant la collecte peut être une couche dopée d'épaisseur par exemple comprise entre 3 nm et 600 nm.

Selon une possibilité de mise en œuvre, la jonction réalisée peut être une homo-jonction de type pn. Une telle jonction peut être obtenue par exemple par diffusion thermique de dopants ou par implantation ionique (suivie d'un recuit d'activation) de la première face 2A principale. Il est également possible de réaliser une telle jonction en faisant croitre une couche semi-conductrice par épitaxie avec un dopage *in situ,* autrement dit réalisé lors de la croissance épitaxiale. La couche 3 réalisée sur une face 2A du substrat, a un dopage de type opposé à celui du substrat 1. On fait ainsi par exemple croitre une couche semi-conductrice dopée n lorsque le substrat 1 est globalement dopé p. Typiquement, la couche 3 dopée réalisée en surface est fortement dopée et peut être notée n+ lorsque le substrat est globalement dopé p, avec par exemple une concentration en dopants comprise entre 10¹³ at.cm⁻³ et 10²¹ at.cm⁻³. La couche 3 fortement dopée peut donc être dopée p+ lorsque le substrat 1 est globalement dopé n avec par exemple une concentration en dopants comprise entre 10¹³ at.cm⁻³ et 10²¹ at.cm⁻³.

D'autres types de jonctions peuvent être prévus.

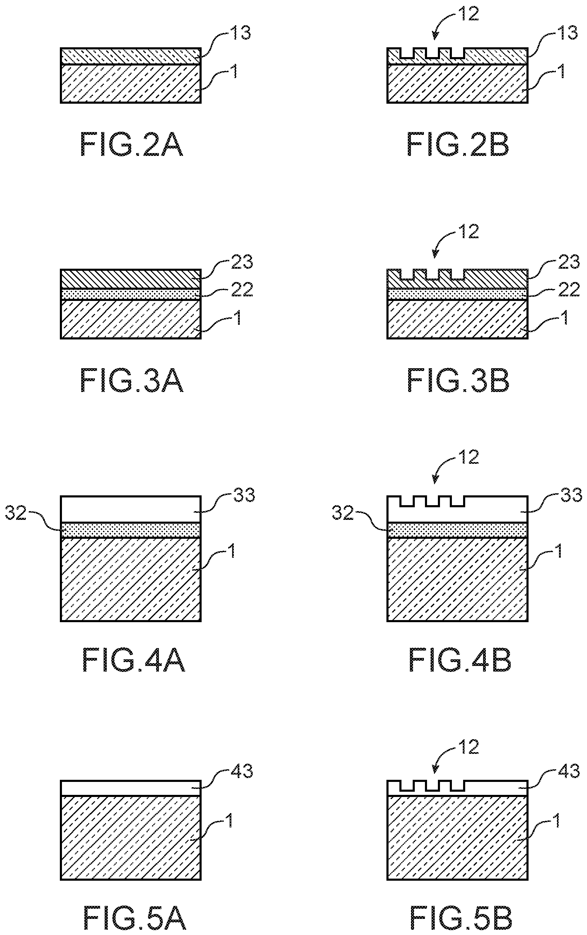

Une hétérojonction semi-conducteur amorphe/semi-conducteur cristallin peut être en particulier réalisée. Pour cela, on peut, comme sur la figure 2A, déposer une ou plusieurs couches de silicium amorphe 13, par exemple par PECVD (pour « Plasma Enhanced Chemical Vapor Déposition ») sur un substrat 1 en silicium cristallin, avec au moins une des couches de silicium amorphe qui est dopée de sorte à avoir un type de conductivité opposé à celui du substrat 1. Par exemple, on réalise au moins une couche de silicium amorphe dopé n sur un substrat silicium cristallin dopé p. En variante, on peut prévoir un substrat dopé n, par exemple au Phosphore et un multi-couches de silicium amorphe dopé p, par exemple au Bore. Cet empilement de plusieurs couches peut avoir une épaisseur par exemple de l'ordre de 10 nm.

Selon une autre possibilité de mise en œuvre, on réalise une jonction Schottky, formée d'au moins une couche de métal sur une couche semi-conductrice. Ainsi, dans l'exemple illustré sur la figure 3A, une couche métallique 23 et réalisée sur le substrat 1 de départ semi-conducteur, par exemple en silicium. Dans ce cas, la couche métallique est de préférence une couche suffisamment fine pour pouvoir être transparente à un rayonnement lumineux dans le domaine visible et/ou dans le proche infrarouge. Par exemple, on peut prévoir une couche métallique à base d'aluminium et d'épaisseur par exemple de l'ordre de 9 nm sur un substrat en silicium dopé p et de résistivité par exemple de l'ordre de 1 ohm.cm.

Il est également possible de réaliser une jonction MIS (pour « Métal-Isolant-Silicium ») formée d'un empilement semi-conducteur-isolant-métal. Ainsi, dans l'exemple illustré sur la figure 3A, une couche métallique 23, par exemple à base d'aluminium, est agencée sur une couche de matériau diélectrique 22, elle-même disposée sur le substrat 1 de départ semi-conducteur, par exemple en silicium. Le matériau diélectrique 22 peut être par exemple un oxyde tel que de l'oxyde de silicium

Un autre mode de réalisation prévoit une jonction formée dans un empilement conducteur-isolant-semi-conducteur. Pour cela, on peut, comme cela est illustré par exemple sur la figure 4A, prévoir une ou plusieurs couches conductrices en silicium polycristallin dopée(s) 33 selon un dopage de type p ou n, opposé à celui, n ou p du substrat 1. Les couches 33 en matériau polycristallin dopé reposent sur une couche de matériau diélectrique 32 qui peut être un oxyde diélectrique, tel que de l'oxyde de silicium d'épaisseur comprise entre 1 nm et 15 nm, par exemple de l'ordre de 1.5 nm. Une telle couche peut être formée à partir d'un substrat en silicium cristallin par exemple dopé au Phosphore, en réalisant un procédé de bullage d'ozone dans de l'eau dé-ionisée. Les couches 33 en matériau polycristallin peuvent être formées par dépôt de silicium amorphe dopé par le bore d'épaisseur par exemple de l'ordre de 40 nm, par PECVD puis recuit. Le recuit peut être réalisé par exemple à une température de l'ordre de 750°C et pendant une durée de l'ordre de 30 minutes.

Un autre mode de réalisation prévoit de former une hétérojonction dotée d'un oxyde métallique sur un semi-conducteur cristallin. Par exemple, comme illustré sur la figure 5A, on forme une couche à base d'oxyde métallique 43 tel que de l'oxyde de molybdène déposé par évaporation sous vide, dans cet exemple directement sur le substrat 1 en silicium cristallin. Une couche d'oxyde de molybdène d'épaisseur de l'ordre de 20 nm peut être par exemple prévue.

Une fois la jonction réalisée, on réalise ensuite des motifs à travers une épaisseur de la couche 3, ou 13, ou 23, ou 33, ou 43 et formant la jonction avec le substrat 1 ou avec une autre couche reposant sur le substrat (figures 1B, 2B, 3B, 4B, 5B).

On effectue pour cela un endommagement localisé et contrôlé d'une région 10 de la couche 3 ou 13, ou 23, ou 33, ou 43.

Dans l'exemple illustré sur la figure 1B, cet endommagement est mis en œuvre au niveau d'un coin du substrat 1. Par gravure mécanique, on réalise ainsi un ou plusieurs motifs 12 à travers au moins une épaisseur de la couche 3 ayant permettant d'obtenir ladite jonction. Le ou les motifs est ou sont répartis selon un agencement déterminé correspondant à au moins un symbole portant une information. Cette information est en particulier une information relative à ladite cellule, par exemple relative à sa technologie donnant en particulier des renseignements sur le type de substrat, ses matériaux constitutifs, son procédé de fabrication. D'autres informations telles que par exemple un identifiant, sa provenance, son fournisseur, sa date de fabrication peuvent être également inscrites afin de permettre d'assurer la traçabilité de la cellule.

Par « gravure mécanique » on entend une gravure réalisée par mise en contact d'un outil sur le substrat ou sur une couche agencée sur le substrat. La gravure mécanique permet de ne pas modifier de façon significative les caractéristiques de la cellule en polarisation directe et, au contraire d'une gravure laser, de ne pas impacter les propriétés photo-électriques de la cellule.

Une telle gravure peut être effectuée par pressage d'un outil comportant le motif complet à reporter, ou bien doté d'une pointe ou d'un ensemble de pointes et du substrat (ou de la couche), et déplacement de la ou des pointes relativement au substrat.

Dans l'exemple illustré sur la figure 1B, pour réaliser un motif 12 comportant un ensemble de rainures 12a, 12b, 12c, typiquement parallèles entre elles, on opère, sur la première face 2A du substrat 1, un balayage d'un outil 101 tel qu'un stylet muni d'une pointe 102, en contact sur la zone 3 de collecte. Le balayage effectué pour former des rainures, est opéré parallèlement à des bords dits « longitudinaux » (bords parallèles à l'axe x sur la figure 1B). Un déplacement du stylet parallèlement à des bords dits « latéraux » (bords parallèles à l'axe y) est opéré pour passer d'une rainure à l'autre. Le mouvement de l'outil permettant de réaliser la gravure mécanique peut être tel, qu'entre deux zones gravées ou deux motifs distincts, une séparation spatiale entre l'outil 101 et le substrat 1 est opérée. En variante, on peut également prévoir d'effectuer l'opération de gravure de sorte que la ou les pointes reste(nt) en contact avec le substrat 1 entre deux motifs à graver.

Dans l'exemple de réalisation particulier illustré, l'ensemble du motif créé par endommagement mécanique localisé est sous forme de rainures parallèles en particulierde différentes largeurs. Ces rainures sont susceptibles de former un code-barres. D'autres types de motifs, portant éventuellement une information codée, peuvent être prévus, par exemple un motif code-barres en deux dimensions (ou code matriciel tel qu'un QR code) formé par exemple d'un ensemble d'éléments non gravés disposés dans une région globalement gravée peuvent être également prévus.

La gravure est réalisée de sorte à creuser au moins dans la couche 3 qui a permis d'obtenir une zone de collecte des charges libres minoritaires du substrat.

Le procédé peut ensuite suivre des étapes de fabrication semblables à celles d'une cellule solaire conventionnelle.

Une fois la fabrication de la cellule solaire achevée, on prévoit de polariser la jonction en inverse, afin que celle-ci puisse émettre de la lumière qui, en fonction du type de jonction mise en œuvre, est émise dans le domaine du rayonnement visible voire dans le proche infrarouge. Préférentiellement, la polarisation s'effectuera pour une différence de potentielle inférieure en valeur absolue à la tension de claquage du dispositif complet.

Un tel type d'émission de rayonnement lumineux a été décrit par exemple dans le document « Photo Emission from Avalanche Breakdown in Silicon » de Chynoweth et al., Physical review volume 102, numéro 2, 1956.

L'endommagement réalisé peut permettre de favoriser le claquage de la jonction lorsque celle-ci est polarisée en inverse. Un tel endommagement permet par conséquent de favoriser l'émission de lumière par la jonction.

La différence de potentiels négative à appliquer au dispositif dépend du type de jonction mis en œuvre et de ses caractéristiques (par exemple sa morphologie, le dopage des couches la constituant).

Pour une homo-jonction, l'Homme du Métier peut trouver des valeurs théoriques ou semi-empiriques de différence de potentiels à appliquer afin de permettre le claquage de la jonction. Ces différences de potentiel sont notamment accessibles dans l'ouvrage « Physics of Semiconductor Devices, 2nd Edition, S. M. Sze », et ce pour différents profils de jonction (abrupte ou avec gradient de concentration), et différentes morphologies de jonction (sphérique ou cylindrique).

Les différences de potentiels à appliquer afin de permettre le claquage de la jonction peuvent également être évaluées de façon empirique, en traçant la caractéristique Courant-Tension de la cellule en polarisation inverse.

Pour obtenir une polarisation inverse adéquate de la jonction, on peut aussi appliquer une différence de potentiels de sorte à polariser en inverse la jonction, puis moduler la tension ou différence de potentiels appliquée jusqu'à obtenir une émission lumineuse. Il est préférable de débuter par des différences de potentiel faibles (en valeur absolue), et d'augmenter pas à pas la valeur absolue de la différence de potentielle appliquée, jusqu'à l'émission de lumière. On peut ainsi déterminer la tension adéquate pour obtenir une émission lumineuse suffisamment intense. De façon préférentielle, il est judicieux de placer la cellule polarisée en inverse ou le module dans un environnement permettant de maintenir sa température à des valeurs inférieures à 60°C, très préférentiellement inférieures à 30°C, par exemple en plaçant la cellule ou le module sur un socle régulé en température. Il peut s'agir d'un socle, par exemple en cuivre, dans lequel de l'eau circule pour permettre le refroidissement, ou encore d'un socle à refroidissement thermoélectrique en particulier doté de module Peltier. Le maintien à basse température protège la cellule d'éventuels échauffements localisés susceptibles de dégrader ses performances.

L'émission de rayonnement lumineux au niveau de la jonction permet de mettre en évidence le ou les motifs gravés et rendre leur lecture plus aisée et plus rapide. La polarisation inverse de la ou des cellules est opérée typiquement pendant la durée de la détection ou de la visualisation.

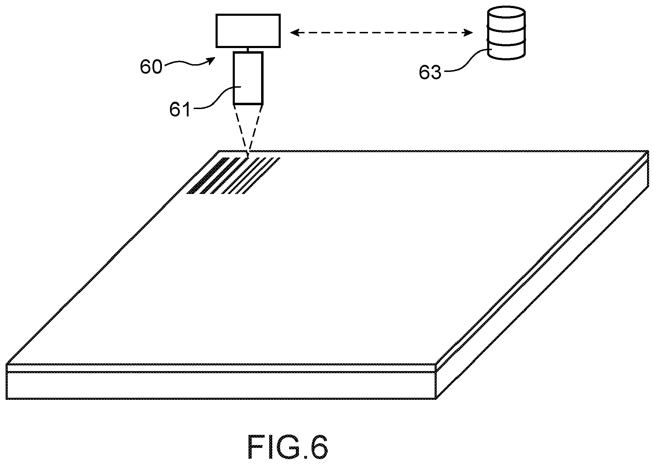

La détection du motif 12 peut être réalisée par exemple comme dans l'exemple de dispositif illustré sur la figure 6 (dispositif qui n'est ici pas représenté à l'échelle), au moyen d'un dispositif 60 de détection, ici muni d'une caméra 61 telle que par exemple une caméra CCD. Dans l'exemple illustré où le motif porte une donnée codée, le dispositif 60 est relié à une base de données 63 permettant de faire la correspondance entre la donnée codée et des informations relatives à la cellule, par exemple à son procédé et/ou à sa technologie de fabrication et/ou aux performances de la cellule et/ou à un identifiant de la cellule. Typiquement, la caméra 61 utilisée permet de faire une acquisition d'image de la cellule voire d'un module complet.

La détection ou visualisation peut être également effectuée tandis que la cellule se trouve intégrée dans un module photovoltaïque complet formé d'un ensemble de cellules assemblées et connectées entre elles.

Comme suggéré précédemment, hormis les étapes de fourniture du substrat, de formation d'une jonction et en particulier d'une zone de collecte de porteurs minoritaires, puis de motifs par endommagement mécanique localisé d'une région de la zone de collecte ou de la jonction, d'autres étapes peuvent être prévues lors de la fabrication d'une cellule solaire mise en œuvre suivant l'invention.

Afin de diminuer la réflectivité de la surface de la cellule et d'augmenter le chemin optique de la lumière dans la cellule, une étape de texturation d'au moins une face du substrat 1 peut être prévue. Cette opération, typiquement réalisée avant formation de la jonction, permet de former en surface un relief, par exemple sous forme de motifs pyramidaux micrométriques. La texturation peut être effectuée par action mécanique, gravure plasma, ou par attaque chimique, par exemple en plaçant le substrat 1 dans un bain contenant une solution de KOH. Dans ce cas, la texturation est généralement mise en œuvre sur les deux faces principales. On peut ensuite effectuer un polissage de la face arrière par voie chimique. Un nettoyage des faces principales par exemple à l'aide de HF/HCl peut être ensuite mis en œuvre.

Le procédé de fabrication de la cellule solaire peut également comprendre la mise en œuvre d'une ou plusieurs couches de passivation, en particulier après avoir formé la jonction et préalablement à la réalisation des motifs. On réalise par exemple une couche de passivation en face arrière du substrat. Au préalable, on effectue typiquement un nettoyage par voie chimique, par exemple à l'aide de HF/HCl.

On réalise ensuite un dépôt d'une ou plusieurs couches diélectriques sur la face arrière, par exemple d'un empilement d'oxyde d'aluminium (AlOₓ) et de nitrure de silicium (SiNₓ). Cet empilement peut être localement ouvert par une irradiation laser.

Le procédé de fabrication de la cellule solaire peut également comporter la formation d'une couche anti-reflet en face avant. Cette couche, par exemple en nitrure de silicium hydrogéné, peut être réalisée après l'étape de formation de motifs par gravure mécanique.

De même, après réalisation des motifs par gravure en face avant, on prévoit typiquement une formation de contacts en face arrière et une formation de contacts en face avant. Les contacts en face arrière peuvent être réalisés par dépôt d'une couche métallique, par exemple en Aluminium, déposée sur la face arrière et qui peut être structurée par sérigraphie.

Les contacts en face avant peuvent être également formés par dépôt métallique, par exemple en Argent, structuré par sérigraphie, par exemple de sorte à former une grille. Une ou plusieurs étapes de recuits thermiques sont ensuite réalisées afin d'activer les matériaux réalisés par sérigraphie et diminuer la résistance série du dispositif.

Un exemple particulier détaillé de réalisation d'une cellule solaire comportant des motifs gravés et susceptible d'émettre un rayonnement lumineux depuis une zone comportant ces motifs, va à présent être donné.

On prévoit ici une cellule solaire de type n-PERT (« Passivated Emitter and Rear Totally Diffused ») réalisée à partir d'un substrat sous forme d'une plaquette de silicium monocristallin de type n, dopée au phosphore et de résistivité 2 Ω.cm. La plaquette est issue d'un tirage Czochralski et a une surface de 156x156 mm², ainsi qu'une épaisseur de l'ordre de 190 µm.

Le substrat est ensuite plongé dans une solution de KOH afin de former une face texturée en face avant et arrière de la plaquette.

On effectue ensuite un nettoyage des faces avant et arrière à l'aide de solutions à base d'HF/HCI.

Puis, une couche barrière, typiquement en nitrure de silicium, est déposée par PECVD sur la face arrière de la plaquette.

Pour réaliser la jonction, on effectue un dopage de type p à l'aide de Bore introduit en face avant du substrat en silicium cristallin. Le dopage est réalisé par diffusion thermique dans un four à tube à une température de l'ordre de de 950°C à partir d'un précurseur BCl₃. Une homojonction de type p+n est ainsi créée en face 1 avant du substrat 1. Une couche de Silicium superficielle très riche en bore également « BRL » (pour Boron-Rich Layer) peut être ensuite enlevée, par exemple par voie chimique.

On grave ensuite les motifs sur une région de la face avant en pressant sur celle-ci un outil tel qu'un peigne doté de pointes en carbure de tungstène. Le diamètre de la zone des pointes en contact avec la plaquette est de l'ordre de 80 µm. Les motifs sont réalisés en appliquant un poids équivalent de l'ordre de 200 g/pointe.

La couche barrière présente en face arrière de la plaquette est ensuite enlevée par voie chimique.

Une autre couche barrière en nitrure de silicium, est ensuite déposée par PECVD sur la face avant de la plaquette, afin de réaliser un dopage en face arrière. Une zone n+ fortement dopée au phosphore est ensuite créée sur la face arrière par diffusion thermique de phosphore à une température voisine de 850°C dans un four à tube, depuis un précurseur POCl₃. La couche barrière présente en face avant est ensuite enlevée par voie chimique ainsi que le verre de phosphore et de silicium présent sur la face arrière.

Un procédé d'oxydation thermique est ensuite typiquement effectué afin d'améliorer la passivation électrique des surfaces.

Des couches anti-reflets en nitrure de silicium hydrogéné sont déposées par PECVD sur les faces avant et arrière de la plaquette.

Puis, des grilles métalliques à base d'alliage d'argent et aluminium pour la face avant, et d'argent pour la face arrière sont réalisées.

La réalisation de ces grilles peut comprendre un dépôt par sérigraphie sous forme de pâte, puis un recuit dans un four à passage est effectué afin de rendre les pâtes de sérigraphie conductrices et de permettre aux espèces métalliques d'interagir avec le silicium.

Une cellule solaire telle que décrite précédemment, peut comme cela a été suggéré plus haut, porter des informations par le biais de ses motifs gravés au niveau d'une jonction émettrice de rayonnement lumineux. Des informations par exemple relatives au procédé de fabrication et/ou à la technologie de fabrication et/ou aux performances de la cellule et/ou un identifiant de la cellule peuvent permettre d'assurer sa traçabilité même une fois avoir intégré cette cellule dans un module photovoltaïque dans lequel une pluralité de cellules sont assemblées. Une information concernant la technologie du module par exemple son procédé de fabrication, le type d'interconnexion mis en œuvre, le type d'encapsulant utilisé, la nature du verre utilisé peut être également inscrite.

Afin d'effectuer une identification de la cellule, on peut ainsi mettre en œuvre une polarisation en inverse de celle-ci de sorte qu'elle émette un rayonnement lumineux mettant en évidence ses motifs et facilitant ainsi la lecture de ses informations, par exemple par le biais d'un appareil ou dispositif de lecture muni d'une caméra. Le marquage des cellules par des motifs gravés et mis en évidence pas émission de rayonnement lumineux peut permettre d'effectuer un tri en particulier en fin de vie de la cellule ou d'un module intégrant cette cellule.

Une telle étape d'identification peut être utilisée en particulier lors d'un processus de tri de cellules solaires, où l'on sépare en plusieurs groupes distincts des cellules identifiées à l'aide d'un procédé tel que décrit précédemment.

Une telle identification et un tel tri peuvent être par ailleurs mis en œuvre lors d'un processus de recyclage de cellule(s) ou de module(s) solaire(s), usagés.

Dans une démarche de recyclage on peut prévoir que des modules PV soient soumis à un tri par technologie avant entrée dans un procédé de démantèlement. On peut en effet prévoir le démantèlement d'une cellule ou d'un module en fonction de l'information identifiée sur celle-ci et qui renseigne par exemple sur sa technologie ou son procédé de fabrication. Le procédé de démantèlement peut différer d'une cellule (ou d'un module) à l'autre en fonction de ses matériaux constitutifs (procédé spécifique de récupération de l'indium présent dans l'oxyde transparent conducteur d'une cellule silicium à hétérojonction, alors qu'une cellule à homojonction suivra le procédé de démantèlement standard). L'information inscrite sur une cellule est susceptible d'indiquer en effet les éléments et matériaux constitutifs de la cellule (ou du module) que l'on peut vouloir extraire afin par exemple de les réintroduire dans un nouveau cycle de production ou de fabrication. On peut également effectuer un démantèlement d'un module en fonction de la technologie du module identifiée par lecture des motifs sur une cellule de ce module. Des modules différents par exemple un module bi-verre d'un côté et un module comportant un verre Tedlar^{®} de l'autre, pouvant être par ailleurs formés de cellules de même technologie, peuvent être ainsi traités de manière différente en fonction de l'information identifiée et subir des procédés de démantèlement différents.

Par exemple, on peut prévoit de séparer les modules composés de cellules à hétérojonction de silicium des modules composés de cellules à homojonction de silicium. Un tel tri en fonction de la technologie des cellules permet d'effectuer une récupération optimisée des matériaux constitutifs des cellules. Un tel tri peut permettre également de réaliser un recyclage sélectif. Les cellules à hétérojonction peuvent comporter par exemple de l'indium et être soumises ensuite à un procédé de recyclage du module spécifique aux cellules à hétérojonction et qui est différent de celui prévu pour des cellules à homojonction ne comportant pas d'Indium.

## Revendications

1. Dispositif comprenant :
- une cellule photovoltaïque munie d'une structure apte à émettre un rayonnement lumineux, ladite cellule photovoltaïque comportant sur une région d'une face (2A) principale, une première couche (3, 13, 23, 33, 43) à travers laquelle un ou plusieurs motifs (12) sont gravés, lesdits un ou plusieurs motifs étant répartis selon un agencement déterminé correspondant à au moins un symbole d'information, en particulier une information donnée relative à ladite cellule, ladite première couche reposant sur une deuxième couche (1) avec laquelle ladite première couche forme une jonction, ladite jonction étant, lorsqu'elle est polarisée en inverse, apte à émettre un rayonnement lumineux mettant en évidence lesdits un ou plusieurs motifs gravés dans ladite première couche (3, 13, 23, 33, 43),
le dispositif étant **caractérisé en ce qu'**il comprend également:
- un circuit de polarisation configuré pour polariser en inverse ladite jonction.

2. Dispositif selon la revendication 1, dans lequel ladite première couche (3) est une couche de matériau semi-conducteur cristallin, ladite deuxième couche étant une couche d'un substrat cristallin (1) ou étant une couche semi-conductrice cristalline reposant sur un substrat, ladite première couche et ladite deuxième couche formant une homo-jonction de type pn.

3. Dispositif selon la revendication 1, dans lequel ladite première couche est une couche semi-conductrice amorphe (13) dopée ou un matériau multicouches (13) composé d'une couche semi-conductrice amorphe intrinsèque et d'une couche semi-conductrice amorphe dopée, ladite deuxième couche étant une couche de substrat cristallin (1) ou étant une couche semi-conductrice cristalline reposant sur un substrat, ladite première couche et ladite deuxième couche formant une hétéro-jonction.

4. Dispositif selon la revendication 1, dans lequel ladite première couche est une couche métallique (23), ladite deuxième couche étant une couche semi-conductrice d'un substrat (1) ou une couche semi-conductrice reposant sur un substrat, ladite première couche et ladite deuxième couche formant une jonction Schottky.

5. Dispositif selon la revendication 1, ladite première couche étant agencée sur une couche (32) de matériau diélectrique reposant sur un substrat, ladite première couche étant une couche métallique ou de matériau semi-conducteur polycristallin dopé (33) d'un type de conductivité opposé à celui du substrat.

6. Dispositif selon la revendication 1, dans lequel ladite première couche est une couche d'oxyde métallique (43), ladite deuxième couche étant une couche de substrat (1) semi-conducteur ou une couche semi-conductrice amorphe agencée sur un substrat (1), ladite première couche et ladite deuxième couche formant une hétéro-jonction.

7. Dispositif selon l'une des revendications 1 à 6, comprenant en outre :
- un moyen d'acquisition d'image tel qu'une caméra, prévu pour faire l'acquisition d'une image de ladite région, ladite tension de polarisation inverse étant appliquée pendant la durée de ladite acquisition.

8. Dispositif selon l'une des revendications 1 à 7, la cellule photovoltaïque étant disposée sur un socle de régulation en température configuré pour maintenir la température de la cellule à une valeur inférieure à 60°C, et préférentiellement inférieure à 30°C.

9. Dispositif selon l'une des revendications 1 à 8, dans lequel lesdits motifs forment un code-barres ou un code matriciel.

10. Procédé d'identification d'une cellule photovoltaïque telle que définie à la revendication 1, le procédé étant **caractérisé en ce qu'**il comprend des étapes de :
- polarisation en inverse de ladite jonction de sorte qu'elle émette un rayonnement lumineux mettant en évidence lesdits motifs gravés dans ladite première couche de ladite cellule,
- lecture de ladite information donnée, en particulier par acquisition d'une image desdits motifs gravés dans ladite première couche en utilisant un moyen d'acquisition d'image.

11. Procédé de tri de cellules photovoltaïques comprenant des étapes de :
- mise en œuvre d'un procédé d'identification selon la revendication 10 sur une première cellule photovoltaïque,
- mise en œuvre d'un procédé d'identification selon la revendication 10 sur une deuxième cellule photovoltaïque,
- répartir ladite première cellule et ladite deuxième cellule en un ou plusieurs groupes en fonction respectivement de l'information donnée lue sur la première cellule et de l'information donnée lue sur la deuxième cellule.

12. Procédé selon la revendication 11, dans lequel la première cellule appartient à un premier module photovoltaïque et dans lequel la deuxième cellule appartient à un deuxième module photovoltaïque distinct dudit premier module photovoltaïque.

13. Procédé selon la revendication 12, dans lequel ladite première cellule comporte un premier symbole d'information indicateur d'une technologie de fabrication dans laquelle les cellules du premier module photovoltaïque sont réalisées ou une technologie de fabrication du premier module.

14. Procédé selon la revendication 13, dans lequel ladite information donnée lue sur ladite première cellule est indicatrice d'une première technologie de fabrication dans laquelle les cellules du premier module photovoltaïque sont réalisées et dans lequel ladite information donnée lue sur la deuxième cellule est indicatrice d'une deuxième technologie de fabrication dans laquelle les cellules du deuxième module photovoltaïque sont réalisées, le procédé comprenant en outre :
- la répartition des cellules du premier module photovoltaïque en un premier groupe de cellules, la répartition des cellules du deuxième module photovoltaïque en un deuxième groupe de cellules distinct du premier groupe.

15. Procédé selon la revendication 14, comprenant en outre préalablement à ladite répartition, le démantèlement dudit premier module photovoltaïque et dudit deuxième module photovoltaïque.

16. Procédé de recyclage de cellule ou de module solaire comprenant :
- la mise en œuvre d'un procédé d'identification selon la revendication 10, sur une cellule photovoltaïque comportant sur une région d'une face (2A) principale, une première couche (3, 13, 23, 33, 43) à travers laquelle un ou plusieurs motifs (12) sont gravés, ladite première couche reposant sur une deuxième couche (1) avec laquelle ladite première couche forme une jonction, lesdits un ou plusieurs motifs étant répartis selon un agencement déterminé correspondant à au moins un symbole d'information donnée, en particulier une information donnée relative à ladite cellule, puis,
- le démantèlement de ladite cellule ou dudit module en fonction de ladite information donnée identifiée par lecture desdits motifs gravés.

## Patentansprüche

1. Vorrichtung, umfassend:
- eine photovoltaische Solarzelle, die mit einer Struktur versehen ist, die geeignet ist, um eine Lichtstrahlung auszugeben, wobei die photovoltaische Solarzelle auf einer Region einer Hauptfläche (2A) eine erste Schicht (3, 13, 23, 33, 43) beinhaltet, durch die ein oder mehrere Motive (12) graviert sind, wobei das eine oder die mehreren Motive entlang einer Anordnung verteilt ist bzw. sind, die mindestens einem Informationssymbol, insbesondere einem Symbol, das in Bezug auf die Zelle gegeben wird, entspricht, wobei die erste Schicht auf einer zweiten Schicht (1) aufliegt, mit der die erste Schicht einen Übergang bildet, wobei der Übergang, wenn er umgekehrt polarisiert ist, geeignet ist, um eine Lichtstrahlung auszugeben, die das eine oder die mehreren Motive, das bzw. die in die erste Schicht (3, 13, 23, 33, 43) graviert ist bzw. sind, anzuzeigen, wobei die Vorrichtung **dadurch gekennzeichnet ist, dass** sie ebenfalls umfasst:
- einen Polarisierungsschaltkreis, der konfiguriert ist, um den Übergang umgekehrt zu polarisieren.

2. Vorrichtung nach Anspruch 1, wobei die erste Schicht (3) eine Schicht aus kristallinem Halbleitermaterial ist, wobei die zweite Schicht eine Schicht aus kristallinem Halbleitermaterial (1) oder eine Schicht aus kristallinem Halbleitermaterial, das auf einem Träger aufliegt, ist, wobei die erste Schicht und die zweite Schicht einen Homo-Übergang vom Typ PN bilden.

3. Vorrichtung nach Anspruch 1, wobei die erste Schicht eine dotierte amorphe Halbleiterschicht (13) oder ein Mehrschichtmaterial (13) ist, das aus einer intrinsischen amorphen Halbleiterschicht und einer dotierten amorphen Halbleiterschicht zusammengesetzt ist, wobei die zweite Schicht eine Schicht eines kristallinen Substrats (1) oder eine auf einem Substrat aufliegende kristalline Halbleiterschicht ist, wobei die erste Schicht und die zweite Schicht einen Hetero-Übergang bilden.

4. Vorrichtung nach Anspruch 1, wobei die erste Schicht eine Metallschicht (23) ist, die zweite Schicht eine Halbleiterschicht eines Substrats (1) oder eine Halbleiterschicht ist, die auf einem Substrat aufliegt, wobei die erste Schicht und die zweite Schicht einen Schottky-Übergang bilden.

5. Vorrichtung nach Anspruch 1, wobei die erste Schicht auf einer Schicht (32) aus dielektrischem Material angeordnet ist, die auf einem Substrat aufliegt, wobei die erste Schicht eine Metallschicht, oder aus einem dotierten polykristallinen Halbleitermaterial (33) eines Leitfähigkeitstyps entgegengesetzt zu jenem des Substrats ist.

6. Vorrichtung nach Anspruch 1, wobei die erste Schicht eine Metalloxidschicht (43) ist, wobei die zweite Schicht eine Schicht eines Halbleitersubstrats (1) ist, oder eine amorphe Halbleiterschicht, die auf einem Substrat (1) angeordnet ist, wobei die erste Schicht und die zweite Schicht einen Hetero-Übergang bilden.

7. Vorrichtung nach einem der Ansprüche 1 bis 6, weiter umfassend:
- ein Bildaufnahmemittel, wie eine Kamera, vorgesehen, um die Aufnahme eines Bildes der Region durchzuführen, wobei die umgekehrte Polarisierungsspannung während der Dauer der Aufnahme angelegt wird.

8. Vorrichtung nach einem der Ansprüche 1 bis 7, wobei die photovoltaische Solarzelle auf einem Temperaturregelungssockel angeordnet ist, der konfiguriert ist, um die Temperatur der Solarzelle auf einem Wert von unter 60 °C, und vorzugsweise unter 30 °C zu halten.

9. Vorrichtung nach einem der Ansprüche 1 bis 8, wobei die Motive einen Barcode oder einen Matrixcode bilden.

10. Verfahren zum Identifizieren einer photovoltaischen Solarzelle nach Anspruch 1, wobei das Verfahren **dadurch gekennzeichnet ist, dass** es die folgenden Schritte umfasst:
- umgekehrtes Polarisieren des Übergangs, derart, dass sie eine Lichtstrahlung ausgibt, die die Motive hervorhebt, die in die erste Schicht der Solarzelle graviert sind,
- Lesen der gegebenen Information, insbesondere durch Aufnehmen eines Bildes der in die erste Schicht gravierten Motive durch Verwenden eines Bildaufnahmemittels.

11. Verfahren zum Sortieren von photovoltaischen Solarzellen, die folgenden Schritte umfassend:
- Umsetzen eines Verfahrens zum Identifizieren nach Anspruch 10 auf einer ersten photovoltaischen Solarzelle,
- Umsetzen eines Verfahrens zum Identifizieren nach Anspruch 10 auf einer zweiten photovoltaischen Solarzelle,
- Verteilen der ersten Solarzelle und der zweiten Solarzelle in einer oder mehreren Gruppen jeweils in Abhängigkeit von der gegebenen Information, die auf der ersten Solarzelle gelesen wird, und der gegebenen Information, die auf der zweiten Solarzelle gelesen wird.

12. Verfahren nach Anspruch 11, wobei die erste Solarzelle einem ersten Photovoltaikmodul angehört, und wobei die zweite Solarzelle einem zweiten Photovoltaikmodul angehört, das sich von dem ersten Photovoltaikmodul unterscheidet.

13. Verfahren nach Anspruch 12, wobei die erste Solarzelle ein erstes Informationssymbol beinhaltet, das auf eine Herstellungstechnologie, mit der die Solarzellen des ersten Photovoltaikmoduls hergestellt werden, oder auf eine Herstellungstechnologie des ersten Moduls hinweist.

14. Verfahren nach Anspruch 13, wobei die gegebene Information, die auf der ersten Solarzelle gelesen wird, auf eine erste Herstellungstechnologie, mit der die Solarzellen des ersten Photovoltaikmoduls hergestellt werden, hinweist, und wobei die gegebene Information, die auf der zweiten Solarzelle gelesen wird, auf eine zweite Herstellungstechnologie, mit der die Solarzellen des zweiten Photovoltaikmoduls hergestellt werden, hinweist, wobei das Verfahren weiter umfasst:
- die Verteilung der Solarzellen des ersten Photovoltaikmoduls in einer ersten Gruppe an Solarzellen, die Verteilung der Solarzellen des zweiten Photovoltaikmoduls in einer zweiten Gruppe an Solarzellen, die sich von der ersten Gruppe unterscheidet.

15. Verfahren nach Anspruch 14, weiter vor der Verteilung den Abbau des ersten Photovoltaikmoduls und des zweiten Photovoltaikmoduls umfassend.

16. Verfahren zum Recycling einer Solarzelle oder eines Solarmoduls, umfassend:
- das Umsetzen eines Verfahrens zum Identifizieren nach Anspruch 10 auf einer photovoltaischen Solarzelle, die auf einer Region einer Hauptfläche (2A) eine erste Schicht (3, 13, 23, 33, 43) beinhaltet, durch die ein oder mehrere Motive (12) graviert sind, wobei die erste Schicht auf einer zweiten Schicht (1) aufliegt, mit der die erste Schicht einen Übergang bildet, wobei das eine oder die mehreren Motive entlang einer Anordnung verteilt ist bzw. sind, die mindestens einem gegebenen Informationssymbol, insbesondere einer gegebenen Information in Bezug auf die Solarzelle entspricht, danach,
- den Abbau der Solarzelle oder des Moduls in Abhängigkeit von der gegebenen Information, die durch das Lesen der gravierten Motive identifiziert wird.

## Claims

1. Device comprising:
- a photovoltaic cell equipped with a structure capable of emitting a light radiation, said photovoltaic cell including on a region of a main face (2A), a first layer (3, 13, 23, 33, 43) through which one or more patterns (12) are engraved, said one or more patterns being distributed according to a predetermined arrangement corresponding to at least one information symbol, in particular a given information item relating to said cell, said first layer resting on a second layer (1) with which said first layer forms a junction, said junction being, when it is reverse biased, capable of emitting a light radiation displaying said one or more patterns engraved in said first layer (3, 13, 23, 33, 43), the device being **characterised in that** it comprises:
- a bias circuit configured to reverse bias said junction.

2. Device according to claim 1, wherein said first layer (3) is a layer of crystalline semiconductor material, said second layer being a layer of a crystalline substrate (1) or being a crystalline semiconductor layer resting on a substrate, said first layer and said second layer forming a pn-type homojunction.

3. Device according to claim 1, wherein said first layer is a doped amorphous semiconductor layer (13) or a multi-layer material (13) consisting of an intrinsic amorphous semiconductor layer and of a doped amorphous semiconductor layer, said second layer being a crystalline substrate layer (1) or being a crystalline semiconductor layer resting on a substrate, said first layer and said second layer forming a heterojunction.

4. Device according to claim 1, wherein said first layer is a metal layer (23), said second layer being a semiconductor layer of a substrate (1) or a semiconductor layer resting on a substrate, said first layer and said second layer forming a Schottky junction.

5. Device according to claim 1, said first layer being arranged on a dielectric material layer (32) resting on a substrate, said first layer being a metal layer or of doped polycrystalline semiconductor material (33) of a conductivity type opposite to that of the substrate.

6. Device according to claim 1, wherein said first layer is a metal oxide layer (43), said second layer being a semiconductor substrate layer (1) or an amorphous semiconductor layer arranged on a substrate (1), said first layer and said second layer forming a heterojunction.

7. Device according to one of the claims 1 to 6, further comprising:
- an image acquisition means such as a camera, provided for carrying out the acquisition of an image of said region, said reverse bias voltage being applied throughout the duration of said acquisition.

8. Device according to one of the claims 1 to 7, the photovoltaic cell being disposed on a temperature regulation base configured to maintain the temperature of the cell at a value below 60°C, and preferably below 30°C.

9. Device according to one of the claims 1 to 8, wherein said patterns form a barcode or a matrix code.

10. Method for identifying a photovoltaic cell such as defined in claim 1, the method being **characterized in that** it comprises steps of:
- reverse biasing said junction so that it emits a light radiation displaying said patterns engraved in said first layer of said cell,
- reading said given information item, in particular by acquisition of an image of said patterns engraved in said first layer by using an image acquisition means.

11. Method for sorting photovoltaic cells comprising steps of:
- implementing an identification method according to claim 10 on a first photovoltaic cell,
- implementing an identification method according to claim 10 on a second photovoltaic cell,
- distributing said first cell and said second cell in one or more groups depending respectively on the given information item read on the first cell and on the given information item read on the second cell.

12. Method according to claim 11, wherein the first cell belongs to a first photovoltaic module and wherein the second cell belongs to a second photovoltaic module distinct from the first photovoltaic module.

13. Method according to claim 12, wherein said first cell includes a first information symbol indicative of a manufacturing technology wherein the cells of the first photovoltaic module are produced or a manufacturing technology of the first module.

14. Method according to claim 13, wherein said given information item read on said first cell is indicative of a first manufacturing technology wherein the cells of the first photovoltaic module are produced and wherein said given information item read on the second cell is indicative of a second manufacturing technology wherein the cells of the second photovoltaic module are produced, the method further comprising:
- the distribution of the cells of the first photovoltaic module in a first group of cells, the distribution of the cells of the second photovoltaic module in a second group of cells distinct from the first group.

15. Method according to claim 14, further comprising prior to said distribution, the dismantling of said first photovoltaic module and of said second photovoltaic module.

16. Solar module or cell recycling method comprising:
- the implementation of an identification method according to claim 10, on a photovoltaic cell including on a region of a main face (2A), a first layer (3, 13, 23, 33, 43) through which one or more patterns (12) are engraved, said first layer resting on a second layer (1) with which said first layer forms a junction, said one or more patterns being distributed according to a predetermined arrangement corresponding to at least one given information symbol, in particular a given information item relating to said cell, then,
- the dismantling of said cell or of said module depending on said given information item identified by reading said engraved patterns.
